# EUROPEAN PATENT APPLICATION

(11) **EP 4 847 662 A1**
(43) Date of publication of application: **02.12.2026**
(21) Application number: 25745200.3
(22) Date of filing: 23.01.2025
(51) Int. Cl.: C23C 16/42, C23C 16/505

(54) **SILICON OXIDE VAPOR-DEPOSITED FILM AND MOLDED ARTICLE INCLUDING SAME**

(30) Priority: 25.01.2024 JP 2024009395
(71) Applicant: THE NISSHIN OILLIO GROUP, LTD., Tokyo 104-8285 (JP)
(72) Inventor: METOKI Junya, Yokohama-shi, Kanagawa 235-8558 (JP); MURANO Yoshihiro, Yokohama-shi, Kanagawa 235-8558 (JP); KURIMOTO Takayuki, Yokohama-shi, Kanagawa 235-8558 (JP); TAKAGI Shun, Yokohama-shi, Kanagawa 235-8558 (JP); HAYAKAWA Tetsuhiko, Yokohama-shi, Kanagawa 235-8558 (JP); OTSUBO Yuki, Yokohama-shi, Kanagawa 235-8558 (JP); ENDO Akane, Yokohama-shi, Kanagawa 235-8558 (JP)
(74) Representative: Hasegawa, Kan
(86) International application number: PCT/JP2025/002051
(87) International publication number: WO 2025/159157

(57) **Abstract**

The purpose of the present invention is to provide: a silicon oxide vapor-deposited film having high sliding property and/or oil-repellent function for an oil/fat (oil and/or fat) or an oil/fat-containing composition; and a molded article coated with the silicon oxide vapor-deposited film having high sliding property and/or oil-repellent function. Specifically, a silicon oxide vapor-deposited film wherein a surface of the silicon oxide vapor-deposited film has, in ion intensities obtained by time-of-flight secondary ion mass spectrometry, a ratio of ion intensity AO to ion intensity B (ion intensity AO/ion intensity B) of 26 or more, is provided.

## Description

### Technical Field

The present invention relates to a silicon oxide vapor-deposited film and a molded article coated with a silicon oxide vapor-deposited film. The present invention particularly relates to a silicon oxide vapor-deposited film having high sliding property and/or oil-repellent function for an oil/fat (oil and/or fat) or an oil/fat-containing composition, and to a molded article including the same.

### Background Art

Conventionally, in order to improve characteristics of various substrates, forming a film on a surface has been performed. For example, in packaging materials, a vapor-deposited film is formed by a plasma CVD method on a surface of a plastic molded article to improve gas barrier property.

For example, a method for producing a plastic container is known, the method being characterized in that, when at least an organosilicon compound and at least one type of oxygen and a gas having oxidizing power are used to form, by a plasma CVD method, on at least one side of a plastic container, a barrier layer (vapor-deposited film) containing silicon oxide and at least one type of compound composed of at least one or two or more elements selected from carbon, hydrogen, silicon, and oxygen, the concentration of the organosilicon compound changes. The flow rate ratio of gas between the organic silicon compound (hexamethyldisiloxane) and oxygen was 1:2, 1:20, and 1:100 (see Patent Literature 1).

It has also been shown that a silicon oxide film produced with a flow rate ratio between an organosilicon compound gas and a gas containing oxygen atoms in a range of 1:3 to 1:50 and having a component ratio of 170 to 200 O atoms and 30 or fewer C atoms relative to 100 Si atoms has gas barrier property (see Patent Literature 2).

Meanwhile, if washability after use and dischargeability of contents are good, as in containers, cooking utensils, and the like, workability is improved and environmental burden is also reduced. Therefore, water repellency and oil repellency are also required as characteristics of substrates such as containers and cooking utensils. As water repellency, for example, a bottle having good drainage property has been proposed by forming an organic silicon compound film containing nitrogen, silicon, carbon, and hydrogen and forming, on the surface thereof, a silicon oxide compound film mainly composed of a silicon oxide compound by a CVD method (flow rate ratio between hexamethyldisiloxane and oxygen gas of 1:4) (see Patent Literature 3). Also, a molded article coated with a silicon oxide vapor-deposited film having good oil repellency has been proposed (Patent Literature 4).

However, although the silicon oxide vapor-deposited film of Patent Literature 4 has oil repellency, there is a problem in that oil repellency deteriorates by long-term contact with an oil/fat or contact with an oil/fat at a high temperature, and a good silicon oxide compound film that maintains oil repellency over a long term or in a high-temperature state has not been sufficiently studied.

### Citation List

### Patent Literatures

Patent Literature 1: Japanese Unexamined Patent Application Publication No. 2000-255579
Patent Literature 2: Japanese Unexamined Patent Application Publication No. 2003-53873
Patent Literature 3: Japanese Unexamined Patent Application Publication No. 2009-46162
Patent Literature 4: Japanese Unexamined Patent Application Publication No. 2023-95740

### Summary of Invention

An object of the present invention is to provide a silicon oxide vapor-deposited film that has a sliding property and/or an oil-repellent function for an oil/fat or an oil/fat-containing composition even when brought into contact with the oil/fat or oil/fat-containing composition over a long term or at a high temperature, and further to provide a molded article coated with a silicon oxide vapor-deposited film that has a sliding property and/or an oil-repellent function for an oil/fat or an oil/fat-containing composition even when brought into contact with the oil/fat or oil/fat-containing composition over a long term or at a high temperature.

As a result of intensive studies, the present inventors found that, by using a silicon oxide vapor-deposited film containing hydroxyl groups and alkoxy groups at a certain ratio, it is possible to obtain a coating film having a high sliding property and/or oil-repellent function for an oil/fat or an oil/fat-containing composition even when brought into contact with the oil/fat or oil/fat-containing composition over a long term or at a high temperature, and a molded article having the coating film, thereby completing the present invention.

That is, one aspect of the present invention may relate to the following.
[1] A silicon oxide vapor-deposited film, wherein a surface of the silicon oxide vapor-deposited film has, in ion intensities obtained by time-of-flight secondary ion mass spectrometry, a ratio of ion intensity AO to ion intensity B (ion intensity AO/ion intensity B) of 26 or more,
   where the ion intensity B is a sum of the intensities of respective ions of a positive ion at m/z 78.99 and a positive ion at m/z 138.95, and the ion intensity AO is a sum of the intensities of respective ions of a negative ion at m/z 31.02, a negative ion at m/z 59.00, a negative ion at m/z 74.99, a positive ion at m/z 102.97, and a negative ion at m/z 134.96.
[2] The silicon oxide vapor-deposited film according to [1], wherein the surface of the silicon oxide vapor-deposited film has, in ion intensities obtained by time-of-flight secondary ion mass spectrometry, a ratio of ion intensity R to ion intensity A (ion intensity R/ion intensity A) of 0.3 or less,
   where the ion intensity A is a sum of the intensities of respective ions of a positive ion at m/z 43.00, a positive ion at m/z 59.03, and a positive ion at m/z 73.05, and the ion intensity R is a total value of the ion intensities of respective ions of a positive ion at m/z 29.04 and a positive ion at m/z 55.06.
[3] The silicon oxide vapor-deposited film according to [1] or [2], wherein the surface of the silicon oxide vapor-deposited film has, in ion intensities obtained by time-of-flight secondary ion mass spectrometry, a ratio of the ion intensity AO to the ion intensity A (ion intensity AO/ion intensity A) of 0.1 or more, and/or a ratio of the total of the ion intensity A and the ion intensity AO to ion intensity S ((ion intensity A+ion intensity AO)/ion intensity S) of 100 or more, and/or a ratio of the ion intensity AO to ion intensity S (ion intensity AO/ion intensity S) of 30 or more,
   where the ion intensity S is an intensity of a positive ion at m/z 43.97, and the ion intensity A is the sum of the intensities of respective ions of a positive ion at m/z 43.00, a positive ion at m/z 59.03, and a positive ion at m/z 73.05.
[4] The silicon oxide vapor-deposited film according to any one of [1] to [3], wherein the silicon oxide vapor-deposited film has a sliding property of 300 seconds or less in the following sliding property test of oil/fat when rapeseed oil is used as the oil:
   sliding property of oil/fat: time (seconds) required for a rear end of an oil/fat droplet of 24±0.5 mg of rapeseed oil on a surface of a silicon oxide vapor-deposited film sample inclined at 70° relative to the vertical to move 6 mm on the sample surface at 23±3°C.
[5] The silicon oxide vapor-deposited film according to any one of [1] to [4], wherein the silicon oxide vapor-deposited film is a film derived from hexamethyldisiloxane.
[6] A molded article having a surface coated with the silicon oxide vapor-deposited film according to any one of [1] to [5].
[7] The molded article according to [6], wherein the molded article is a container, piping, or a cooking utensil molded from a material selected from resin, glass, metal, ceramic clay, and paper.
[8] A method for producing a molded article coated with the silicon oxide vapor-deposited film, the method comprising: (A) a step of preparing a molded article; and (B) a step of coating a surface of the molded article with the silicon oxide vapor-deposited film according to any one of [1] to [5].
[9] The production method according to [8], wherein the coating is performed by a plasma CVD method using an organosilicon compound and an optional oxidizing gas as reaction gases.
[10] The production method according to [8] or [9], wherein the silicon oxide vapor-deposited film is a film derived from hexamethyldisiloxane.

According to the present invention, it is possible to provide a silicon oxide vapor-deposited film excellent in sliding property and/or oil repellency for an oil/fat or an oil/fat-containing composition even when brought into contact with the oil/fat or oil/fat-containing composition over a long term or at a high temperature. In long-term contact with an oil/fat, the function can be maintained, for example, for 8 weeks or longer at 100°C or lower or 60°C or lower, or for a long period of 128 weeks at 40°C or lower or near room temperature (23°C±3°C). In addition, also in heat resistance (high-temperature durability), the function can be maintained at 100 to 250°C or at 150 to 200°C. In addition, a molded article having a surface coated with the silicon oxide vapor-deposited film is expected to allow oil/fat stains to be easily removed and to have good washability against oil/fat stains. In addition, when the molded article is a container, piping, or the like, it is also expected to have good oil drainage and to be unlikely to cause oil/fat residue.

### Description of Embodiments

Hereinafter, the present invention will be described in detail by way of examples. In the embodiment of the present invention, A (numerical value) to B (numerical value) means A or more and B or less. The preferable aspects, more preferable aspects, and the like exemplified below can be appropriately used in combination with one another regardless of expressions such as "preferable" and "more preferable." In addition, descriptions of numerical ranges are examples, and ranges formed by appropriately combining upper limits and lower limits of each range and numerical values of Examples can also be preferably used regardless of expressions such as "preferable" and "more preferable." Further, terms such as "containing" or "including" may be appropriately read as "consisting essentially of" or "consisting only of."

### [Silicon Oxide Vapor-Deposited Film]

The silicon oxide vapor-deposited film of the present invention is a silicon oxide vapor-deposited film in which a surface of the silicon oxide vapor-deposited film has, in ion intensities obtained by time-of-flight secondary ion mass spectrometry, (a) a ratio of ion intensity AO to ion intensity B (ion intensity AO/ion intensity B) of 26 or more. The silicon oxide vapor-deposited film of the present invention is preferably a silicon oxide vapor-deposited film in which a surface of the silicon oxide vapor-deposited film has, in ion intensities obtained by time-of-flight secondary ion mass spectrometry, (b) a ratio of ion intensity R to ion intensity A (ion intensity R/ion intensity A) of 0.3 or less, and/or (c) a ratio of the ion intensity AO to ion intensity A (ion intensity AO/ion intensity A) of 0.1 or more or 0.2 or more, and/or (d) a ratio of the total of ion intensity A and the ion intensity AO to ion intensity S ((ion intensity A+ion intensity AO)/ion intensity S) of 100 or more, and/or (e) a ratio of the ion intensity AO to ion intensity S (ion intensity AO/ion intensity S) of 30 or more. However, ion s, ion a, ion ao, ion b, ion r, ion intensity S, ion intensity A, ion intensity AO, ion intensity B, and ion intensity R are as follows.

Ion s is a positive ion at m/z 43.97.

Ion a is a positive ion at m/z 43.00, a positive ion at m/z 59.03, and a positive ion at m/z 73.05.

Ion ao is a negative ion at m/z 31.02, a negative ion at m/z 59.00, a negative ion at m/z 74.99, a positive ion at m/z 102.97, and a negative ion at m/z 134.96.

Ion b is a positive ion at m/z 78.99 and a positive ion at m/z 138.95.

Ion r is a positive ion at m/z 29.04 and a positive ion at m/z 55.06.

Ion intensity S is the intensity of a positive ion at m/z 43.97.

Ion intensity A is the sum of the intensities of respective ions of a positive ion at m/z 43.00, a positive ion at m/z 59.03, and a positive ion at m/z 73.05.

Ion intensity AO is the sum of the intensities of respective ions of a negative ion at m/z 31.02, a negative ion at m/z 59.00, a negative ion at m/z 74.99, a positive ion at m/z 102.97, and a negative ion at m/z 134.96.

Ion intensity B is the sum of the intensities of respective ions of a positive ion at m/z 78.99 and a positive ion at m/z 138.95.

Ion intensity R is the sum of the ion intensities of respective ions of a positive ion at m/z 29.04 and a positive ion at m/z 55.06.

In the present invention, ions detected in time-of-flight secondary ion mass spectrometry are identified by m/z (the value obtained by dividing the mass m of an ion by the valence of the ion: a dimensionless value). The intensity of an ion (ion intensity) is a value dependent on the number of ions detected by time-of-flight secondary ion mass spectrometry (a value detected for each ion of each m/z).

The silicon oxide vapor-deposited film of the present invention can be produced by a plasma CVD method using a reactive gas containing an organosilicon compound, and it is assumed that the sliding property and/or oil repellency for an oil/fat or an oil/fat-containing composition is exhibited by leaving hydroxyl groups and alkoxy groups in the silicon oxide vapor-deposited film at a certain ratio.

Since the content of a component containing hydroxyl groups and/or alkoxy groups and/or alkyl groups in the silicon oxide vapor-deposited film correlates with the intensity of peaks derived from functional groups obtained by analyzing a surface of the silicon oxide vapor-deposited film by time-of-flight secondary ion mass spectrometry (TOF-SIMS), the silicon oxide vapor-deposited film of the present invention requires that, in time-of-flight secondary ion mass spectrometry, the ion intensity of ions assumed to contain hydroxyl groups and/or alkoxy groups and/or alkyl groups relative to the ion intensity of ions assumed to be derived only from silicon oxide be at a certain ratio.

The ion assumed to be derived only from silicon oxide (ion s) is a positive ion at m/z 43.97 (SiO)), and the ion intensity of the ion is ion intensity S. The ions assumed to contain alkyl groups (ion a) are a positive ion at m/z 43.00 (SiCH₃), a positive ion at m/z 59.03 (SiC₂H₇), and a positive ion at m/z 73.05 (SiC₃H₉), and the sum of these ion intensities is ion intensity A. The ions assumed to contain alkoxy groups (ion ao) are a negative ion at m/z 31.02 (CH₃O), a negative ion at m/z 59.00 (SiCH₃O), a negative ion at m/z 74.99 (SiCH₃O₂), a positive ion at m/z 102.97 (Si₂CH₃O₂), and a negative ion at m/z 134.96 (Si₂CH₃O₄), and the sum of these ion intensities is ion intensity AO. Further, the ions assumed to contain hydroxyl groups (ion b) are a positive ion at m/z 78.99 (SiO₃H₃) and a positive ion at m/z 138.95 (Si₂O₅H₃), and the sum of these ion intensities is ion intensity B. The ions assumed to be hydrocarbon-only ions (ion r) are a positive ion at m/z 29.04 (C₂H₅) and a positive ion at m/z 55.06 (C₄H₇), and the sum of these ion intensities is ion intensity R.

The silicon oxide vapor-deposited film of the present invention is a silicon oxide vapor-deposited film in which, in ion intensities obtained by time-of-flight secondary ion mass spectrometry on the surface of the silicon oxide vapor-deposited film, (a) the ratio of ion intensity AO to ion intensity B (ion intensity AO/ion intensity B) is 26 or more, preferably 30 or more, more preferably 50 or more, still more preferably 100 or more, even more preferably 150 or more, and particularly preferably 200 or more. The silicon oxide vapor-deposited film of the present invention preferably has, in ion intensities obtained by time-of-flight secondary ion mass spectrometry on the surface of the silicon oxide vapor-deposited film, (b) a ratio of ion intensity R to ion intensity A (ion intensity R/ion intensity A) of 0.3 or less, preferably 0.2 or less, and still preferably less than 0.1. It is a silicon oxide vapor-deposited film in which (c) the ratio of the ion intensity AO to the ion intensity A (ion intensity AO/ion intensity A) is 0.1 or more, preferably may be 0.1 to 1.0, and more preferably is 0.1 to 0.6. As another aspect, the silicon oxide vapor-deposited film of the present invention is a silicon oxide vapor-deposited film in which, in ion intensities obtained by time-of-flight secondary ion mass spectrometry on the surface of the silicon oxide vapor-deposited film, (d) the ratio of the total of ion intensity A and ion intensity AO to ion intensity S ((ion intensity A+ion intensity AO)/ion intensity S) is 100 or more, preferably may be 200 or more, more preferably is 300 or more, and still preferably is 400 or more.

In addition, the silicon oxide vapor-deposited film of the present invention is a silicon oxide vapor-deposited film in which, in ion intensities obtained by time-of-flight secondary ion mass spectrometry on the surface of the silicon oxide vapor-deposited film, (a)' the ratio of ion intensity AO to ion intensity B (ion intensity AO/ion intensity B) is preferably 20000 or less or 16000 or less, more preferably any of 15000 or less, 13500 or less, 800 or less, 500 or less, or 400 or less. In addition, the silicon oxide vapor-deposited film of the present invention may have, in ion intensities obtained by time-of-flight secondary ion mass spectrometry on the surface of the silicon oxide vapor-deposited film, (b)' a ratio of ion intensity R to ion intensity A (ion intensity R/ion intensity A) that is not below 0.0 or that exceeds 0.0. In addition, the silicon oxide vapor-deposited film of the present invention is a silicon oxide vapor-deposited film in which, in ion intensities obtained by time-of-flight secondary ion mass spectrometry on the surface of the silicon oxide vapor-deposited film, (c)' the ratio of the ion intensity AO to the ion intensity A (ion intensity AO/ion intensity A) is preferably 1 or less and more preferably 0.6 or less. In addition, the silicon oxide vapor-deposited film of the present invention is a silicon oxide vapor-deposited film in which, in ion intensities obtained by time-of-flight secondary ion mass spectrometry on the surface of the silicon oxide vapor-deposited film, (d)' the ratio of the total of ion intensity A and ion intensity AO to ion intensity S ((ion intensity A+ion intensity AO)/ion intensity S) is preferably 60000 or less or 45000 or less, more preferably 42000 or less or 600 or less, and still preferably 41500 or less or 500 or less.

As still another aspect, the silicon oxide vapor-deposited film of the present invention is a silicon oxide vapor-deposited film in which, in ion intensities obtained by time-of-flight secondary ion mass spectrometry on the surface of the silicon oxide vapor-deposited film, (e) the ratio of ion intensity AO to ion intensity S (ion intensity AO/ion intensity S) may be 30 or more, preferably is 40 or more, more preferably is 80 or more, still more preferably is 100 to 8000, and particularly preferably is 100 to 5000.

In addition, in the ion intensities, (f) the ratio of ion intensity A to ion intensity S (ion intensity A/ion intensity S) is preferably 80 or more, more preferably 200 or more, still more preferably 300 or more, and particularly preferably 1000 or more.

Here, as for the conditions (a) to (f) and (a)' to (d)' above, as long as condition (a) is satisfied, one or more of the conditions (b) to (f) and (a)' to (d)' above may or may not be satisfied in combination.

In the present invention, measurement by time-of-flight secondary ion mass spectrometry can be performed using a commercially available apparatus; for example, a time-of-flight secondary ion mass spectrometer ("TOF.SIMS 5" manufactured by IONTOF GmbH, Germany, sold by Hitachi High-Tech Science Corporation, measurement region: 500 µm square, primary ion source: Bi) can be used.

Since the silicon oxide vapor-deposited film of the present invention can achieve sliding property and/or oil repellency for an oil/fat or an oil/fat-containing composition by covering the surface, the thickness of the film is considered to have no particular influence. The thickness of the film is not particularly limited, but is preferably 1 to 800 nm, more preferably 5 to 500 nm, still more preferably 8 to 400 nm, even more preferably 10 to 300 nm, and most preferably 10 to 150 nm.

The thickness of the silicon oxide vapor-deposited film can be measured using, for example, an optical thickness meter (model number: OPTM-A1) manufactured by Otsuka Electronics Co., Ltd.; a microscopic automatic film thickness measurement system (model number: F54-XY-200-UV) manufactured by Filmetrics, Inc.; a stylus-type film thickness meter "DEKTAK" manufactured by Bruker Corporation; or by preparing a cross section of the film and measuring it with a field-emission scanning electron microscope "JSM-7800FPRIME" manufactured by JEOL Ltd. (magnification: 30,000 times, accelerating voltage: 2 kV, working distance: 10.3 mm).

### [Molded Article]

The molded article of the present invention is a molded article having a surface coated with the above-described silicon oxide vapor-deposited film. The coating of the surface may be all or part of the inner and outer surfaces of the molded article, but from the viewpoint of dischargeability of contents, it preferably means coating of the inner surface of the molded article. The above-described surface means the outermost layer of the molded article. In addition, as for the silicon oxide vapor-deposited film of the present invention, another coating film may be present between the substrate of the molded article being coated and the coating layer according to the present invention.

The molded article (substrate) of the present invention is preferably molded from a material selected from the group consisting of resin, glass, metal, and paper. By having the above-described silicon oxide vapor-deposited film on the surface of the molded article, it is possible to obtain a molded article imparted with prevention of oil/fat stains and improvement in removability of oil. Suitable resins include thermoplastic resins known per se, for example, low-density polyethylene, high-density polyethylene, polypropylene, poly-1-butene, poly-4-methyl-1-pentene, polyolefins (for example, polyolefins such as random or block copolymers among α-olefins such as ethylene, propylene, 1-butene, and 4-methyl-1-pentene), ethylene/vinyl compound copolymers (for example, ethylene/vinyl acetate copolymer, ethylene/vinyl alcohol copolymer, ethylene/vinyl chloride copolymer, and the like), styrene resins (for example, polystyrene, acrylonitrile/styrene copolymer, ABS, α-methylstyrene/styrene copolymer, and the like), polyvinyl compounds (for example, polyvinyl chloride, polyvinylidene chloride, vinyl chloride/vinylidene chloride copolymer, polymethyl acrylate, polymethyl methacrylate, and the like), polyamides (for example, nylon 6, nylon 6-6, nylon 6-10, nylon 11, nylon 12, and the like), thermoplastic polyesters (for example, polyethylene terephthalate, polybutylene terephthalate, polyethylene naphthalate, and the like), polycarbonate, polyphenylene oxide, biodegradable resins such as polylactic acid, or mixtures thereof. More preferable resins are polyethylene, polyethylene terephthalate, and the like. In addition, the metal is preferably one or more metals selected from iron, nickel, copper, zinc, lead, aluminum, chromium, titanium, and the like, or an alloy containing one or more of the metals as a main component, and more preferably stainless steel.

These molded articles may be films, sheets, piping, containers, and the like, and may also be cooking utensils. Examples of piping include tubes, valves, nozzles, and the like. Examples of containers include bottles, tanks, cups, bags, dishes, and the like, as well as caps, nozzles, and the like constituting containers. Examples of cooking utensils include colanders, nets, cooking stoves, microwave ovens, and the like, as well as ventilation fans, cooking counters, and the like attached to kitchens. In particular, molded articles such as bottles, tanks, valves, and nozzles for oils/fats are preferable. In addition, the oil/fat is preferably edible. The portion of the molded article coated with the silicon oxide vapor-deposited film may be all or part of the molded article, and in particular, may be only the surface portion with which an oil/fat or an oil/fat-containing composition comes into contact.

The molded article of the present invention preferably has a contact angle of refined rapeseed oil at 20°C on the surface covered with the above-described silicon oxide vapor-deposited film of 25° or more, more preferably 30 to 70°, still more preferably 35 to 60°, and most preferably 33 to 55°.

### (Sliding Property of Oil/Fat or Oil/Fat-Containing Composition)

The molded article of the present invention has a sliding property of an oil/fat or an oil/fat-containing composition measured under the following conditions on the surface covered with the above-described silicon oxide vapor-deposited film of, for example, within 300 seconds, preferably within 60 seconds, more preferably within 20 seconds, and still more preferably within 10 seconds, and a shorter time is more preferable. For example, the sliding property of the oil/fat or oil/fat-containing composition can be judged to become better in the following order: more than 60 seconds to 300 seconds, more than 20 seconds to 60 seconds, more than 10 seconds to 20 seconds, and within 10 seconds.

Sliding property of oil/fat or oil/fat-containing composition: time (seconds) required for a rear end of an oil/fat droplet (or liquid droplet) of 24±0.5 mg, such as rapeseed oil, on a sample surface inclined at 70° relative to the vertical to move 6 mm on the sample surface at 23±3°C

Here, the sliding property may be measured for an oil/fat or any product containing an oil/fat (oil/fat-containing composition). In the present specification, the term "oil" may mean not only oil indicating liquid oil/fat, but also oil/fat and any product containing oil/fat (oil/fat-containing composition). For example, the "oil" in oil repellency may mean not only oil or oil/fat, but also oil repellency of an oil/fat component in an oil/fat-containing composition. Oil repellency of an oil/fat-containing composition such as dressing may be evaluated by the amount of the oil/fat-containing composition discharged from a container (residual liquid amount). Further, in the present specification, "oil," "oil/fat," and "oil/fat-containing composition" may be read interchangeably.

Measurement is performed with reference to the rear end of an oil/fat droplet such as rapeseed oil (or a liquid droplet), that is, the contact point located uppermost among contact points between the sample surface and the oil/fat droplet (or liquid droplet) on the inclined sample surface. Rapeseed oil may be dropped onto a sample surface inclined at 70° relative to the vertical, but may also be dropped onto a horizontally installed sample surface and then measured after the sample surface is inclined at 70° relative to the vertical. The sample to be measured is a container for storing an oil/fat or oil/fat-containing composition, but the sample may be measured as is, or a smooth part of the container for storing the oil/fat or oil/fat-containing composition to be measured may be cut out and measured as a flat plate or substantially flat plate sample. Known methods can be used as a method of inclining the sample at 70° relative to the vertical, and for example, "Stage Angle Inclination AG85" manufactured by AS ONE CORPORATION or the like may be used.

The oil/fat dropped onto the sample surface of the container for storing an oil/fat or oil/fat-containing composition is, for example, rapeseed oil. Refined rapeseed oil can be used, and rapeseed oil sold as edible oil or rapeseed oil sold as a reagent can be used. As the rapeseed oil sold as edible oil, rapeseed oil corresponding to "refined rapeseed oil" or "rapeseed salad oil" in "edible rapeseed oil" under the Japanese Agricultural Standard (JAS) for Edible Vegetable Oils and Fats (Ministry of Agriculture, Forestry and Fisheries Notification No. 681 of August 19, 2019) can be used. For example, "Nisshin Canola Oil" (manufactured by The Nisshin OilliO Group, Ltd.) or the like can be used. In addition, as a reagent, "Rapeseed Oil" (manufactured by FUJIFILM Wako Pure Chemical Corporation: Wako 1st Grade) or the like can be used. In order to improve the visibility of rapeseed oil, an oil-soluble colorant may be added. For example, β-carotene can be added to rapeseed oil at about 0.1% by mass. Addition of β-carotene to this extent does not substantially affect the value of the sliding property of the oil/fat itself (the value of the sliding property of the oil/fat does not substantially vary depending on the presence or absence of β-carotene). Refined rapeseed oil usually contains 51 to 66% by mass oleic acid, 19 to 28% by mass linoleic acid, 2 to 11% by mass linolenic acid, 3 to 6% by mass palmitic acid, and 1 to 3% by mass stearic acid. The dropping amount of the mixed oil/fat is 24±0.5 mg, and preferably is about 24.36 mg, which is one drop from a commercially available dropper. In addition, when an oil/fat-containing composition is stored in a container, instead of the oil/fat, a composition containing various oils/fats, such as emulsified dressing (including mayonnaise and mayonnaise-type dressing) or separated dressing, may be used, and the sliding property may be measured in the same manner as above.

### [Method for Producing Molded Article]

The molded article of the present invention is produced by coating a molded article with a silicon oxide vapor-deposited film by a plasma CVD method using an organosilicon compound and an optional oxidizing gas as reaction gases.

### (Organosilicon Compound and Oxidizing Gas)

In the method for producing a molded article of the present invention, the organosilicon compound is used as a silicon source for forming the silicon oxide vapor-deposited film. As the organosilicon compound, organosilane compounds (for example, hexamethyldisilane, vinyltrimethylsilane, methylsilane, dimethylsilane, tetramethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane, methyltriethoxysilane, and the like), organic siloxane compounds (for example, octamethylcyclotetrasiloxane, 1,1,3,3-tetramethyldisiloxane, hexamethyldisiloxane, and the like), diethoxydimethylsilane, dimethyldimethoxysilane, and the like are used. In addition to these materials, silazanes such as hexamethyldisilazane, aminosilanes, and the like can also be used. These organosilicon compounds can be used alone or in a combination of two or more types. In addition, silane (SiH₄) or silicon tetrachloride can be used in combination with the above-described organosilicon compound. As the organosilicon compound, one having, as an organic functional group, a functional group selected from a methyl group, a methoxy group, an ethyl group, and an ethoxy group is preferable, one having an ethoxy group and/or a methoxy group is more preferable, and one having only ethoxy groups is still more preferable. In addition, an organosilicon compound having only methyl groups is also still preferable.

Tetraethoxysilane, tetramethoxysilane, hexamethyldisilazane, hexamethyldisiloxane, and the like are preferable, and an organosilicon compound consisting only of hexamethyldisiloxane or containing hexamethyldisiloxane is more preferable. The organosilicon compound preferably does not contain fluorine.

As the oxidizing gas, oxygen or NOx is used, and oxygen is preferable. As the carrier gas or discharge-stabilizing gas, a rare gas such as argon or helium is used.

In the method for producing a molded article of the present invention, it is preferable to coat the molded article with the silicon oxide vapor-deposited film by a plasma CVD method in which the ratio of the flow rate (volume) of the oxidizing gas to the total flow rate (volume) of the reaction gases is 0 to 95% by volume. By setting the same conditions, it is possible to obtain a silicon oxide vapor-deposited film particularly excellent in sliding property and/or oil repellency for an oil/fat or an oil/fat-containing composition. The ratio of the flow rate (volume) of the oxidizing gas to the total flow rate (volume) of the reaction gases is more preferably 1 to 65% by volume or 0 to 60% by volume, still more preferably 2 to 40% by volume or 0 to 30% by volume, and most preferably 5 to 10% by volume. The flow rate of the reaction gases depends on the coating area of the molded article to be treated, but for example, when coating the inner surface of a plastic container having a capacity of 200 mL to 1.5 L, the reaction gases are preferably supplied at a flow rate of 3 to 2000 sccm, particularly 5 to 600 sccm, per container. The term "sccm" means the amount (cc or ml) of gas flowing for 1 minute under conditions of 0°C and 1 atm.

### (Plasma CVD Method)

In the present invention, in an atmosphere containing the above-described organosilicon compound, optional oxidizing gas, and carrier gas as needed, plasma treatment by a plasma CVD method is performed on the surface of a substrate held in a plasma treatment chamber to form the vapor-deposited film having the above-described composition.

During plasma treatment, the pressure during film formation is preferably 1 to 200 Pa, and more preferably 3 to 100 Pa, in order to keep the plasma treatment chamber at a degree of vacuum at which glow discharge occurs. In this state, the silicon oxide vapor-deposited film is formed by glow discharge supplied with microwaves (300 MHz to 300 GHz), high frequency (1 to 300 MHz), or the like. For example, the output of the microwaves is preferably in a range of 10 to 1000 W, and more preferably 20 to 1000 W. The frequency of the microwaves is preferably 500 MHz to 30 GHz, and more preferably 1 to 10 GHz. The output of the high frequency is preferably 20 to 1500 W, and more preferably 30 to 1500 W. The frequency of the high frequency is preferably 1 to 100 MHz, more preferably 1 to 30 MHz, and still more preferably 10 to 15 MHz.

In the method for producing a molded article of the present invention, it is sufficient that the outermost layer of the molded article be a silicon oxide vapor-deposited film coated under the above conditions, and a molded article coated under other conditions may be further coated under the above production conditions. In addition, the conditions of the plasma CVD method may be changed, such as by changing the supply amount of the oxidizing gas, and finally coating may be performed under the above production conditions.

### Examples

Next, the present invention will be described in further detail by giving Examples, Comparative Examples, and Reference Examples, but the present invention is not limited thereto in any way. Further, in the following, "%" means % by mass unless otherwise specified.

In the tables, "AO/B" means "ion intensity AO/ion intensity B," "AO/A" means "ion intensity AO/ion intensity A," "(A+AO)/S" means "(ion intensity A+ion intensity AO)/ion intensity S," "AO/S" means "ion intensity AO/ion intensity S," "A/S" means "ion intensity A/ion intensity S," and "R/A" means "ion intensity R/ion intensity A."

### [Analysis Method]

### (Surface Functional Group Analysis)

Using a time-of-flight secondary ion mass spectrometer ("TOF.SIMS 5" sold by Hitachi High-Tech Science Corporation, accelerating voltage: 30 kV, measurement region: 500 µm square, primary ion source: Bi (bismuth)), the surfaces of silicon oxide vapor-deposited film samples of Examples and Comparative Examples were analyzed. From the ion intensities of the obtained peaks, the ratio of ion intensity AO to ion intensity B (ion intensity AO/ion intensity B), the ratio of ion intensity AO to ion intensity A (ion intensity AO/ion intensity A), the ratio of the total of ion intensity A and ion intensity AO to ion intensity S ((ion intensity A+ion intensity AO)/ion intensity S), the ratio of ion intensity AO to ion intensity S (ion intensity AO/ion intensity S), the ratio of ion intensity A to ion intensity S (ion intensity A/ion intensity S), and the ratio of ion intensity R to ion intensity A (ion intensity R/ion intensity A) were calculated.

The intensity of an ion (ion intensity) referred to herein is a value dependent on the number of ions detected by time-of-flight secondary ion mass spectrometry (a value detected for each ion of each m/z). Ion intensity S was defined as the intensity of a positive ion at m/z 43.97, ion intensity A was defined as the total value of the intensities of respective ions of a positive ion at m/z 43.00, a positive ion at m/z 59.03, and a positive ion at m/z 73.05, ion intensity AO was defined as the total value of the intensities of respective ions of a negative ion at m/z 31.02, a negative ion at m/z 59.00, a negative ion at m/z 74.99, a positive ion at m/z 102.97, and a negative ion at m/z 134.96, and ion intensity B was defined as the total value of the intensities of respective ions of a positive ion at m/z 78.99 and a positive ion at m/z 138.95. Ion intensity R was defined as the total value of the ion intensities of respective ions of a positive ion at m/z 29.04 and a positive ion at m/z 55.06.

### (Film Thickness)

The film thicknesses of the silicon oxide vapor-deposited films of Examples and Comparative Examples were measured using an optical thickness meter (model number: OPTM-A1) manufactured by Otsuka Electronics Co., Ltd. The reflective objective lens was a 20× lens, and the measurement spot was 10 µm.

### (Contact Angle)

The contact angle meter ("DMo-502" manufactured by Kyowa Interface Science Co., Ltd.) was used, and measurement was performed with the setting of "contact angle measurement [droplet method]" in the contact angle meter. The liquid used for measurement of the contact angle was refined rapeseed oil ("Nisshin Canola Oil" manufactured by The Nisshin OilliO Group, Ltd.), and the amount of liquid used in one measurement was 2.0 µL. For supplying the oil/fat in the contact angle meter, a "Teflon (registered trademark)-coated needle" (manufactured by Kyowa Interface Science Co., Ltd.) was used. Since the oil has high viscosity and wets and spreads over time after landing on the surfaces of the silicon oxide vapor-deposited film samples of Examples and Comparative Examples, a value at 50 seconds after landing, when the contact angle became stable to a certain extent, was recorded.

For analysis, the θ/2 method (the radius r and height h of a liquid droplet were obtained by image processing, and θ=2arctan(h/r) was calculated) was used.

### (Sliding Property of Oil/Fat)

The container for storing oil/fat (PET container: usable capacity 600 g, inner diameter of upper end opening 30.3 mm, height 218.7 mm) was prepared. From a flat portion of the storage container before being filled with oil/fat, a 2 cm square PET plate was cut out, and one drop (about 24.36 mg) of refined rapeseed oil ("Nisshin Canola Oil" manufactured by The Nisshin OilliO Group, Ltd., 99.9%) colored with carotene ("β-Carotene 30% FS" manufactured by DMS, 0.1%) was dropped using a dropper. Immediately thereafter, the sample was placed on a stage ("Stage Angle Inclination" manufactured by AS ONE CORPORATION) set at an inclination of 70° relative to the vertical direction, and the time required for the rear end of the oil/fat droplet (the contact point located uppermost among contact points between the evaluation sample surface and the oil/fat droplet on the inclined evaluation sample surface) to move 6 mm on the sample surface was measured. The temperature during measurement was room temperature (23°C).

Evaluation was performed based on the following A to E criteria according to the moving time, and if the evaluation was A to D, it was determined that sliding property of oil/fat and/or an oil-repellent effect was present. Here, it can be judged that the shorter the moving time, the higher and better the sliding property of oil/fat and/or the oil-repellent effect.
A evaluation: within 10 seconds
B evaluation: more than 10 seconds to 20 seconds
C evaluation: more than 20 seconds to 60 seconds
D evaluation: more than 60 seconds to 300 seconds
E evaluation: more than 300 seconds

### (Reduction Ratio of Residual Oil/Fat Amount)

Oil/fat storage containers of Examples and Comparative Examples were prepared as container samples.

When the container sample was a filled PET sample (a container sample obtained by filling a polyethylene terephthalate container coated with a silicon oxide vapor-deposited film, described later, with rapeseed oil or the like and sealing the same), after the cap was removed and the upper end opening of the container was opened, the container was quickly inclined at an angle of 160° relative to the vertical to discharge the rapeseed oil. In addition, when the container sample was a filled pillow sample (a container sample obtained by forming a film sample coated with a silicon oxide vapor-deposited film, described later, into a pillow shape, filling the pillow shape with rapeseed oil or the like, and sealing the same), after the heat-sealed portion of the opening was cut and the upper end opening of the container was opened, the container was quickly inclined at an angle of 180° relative to the vertical to discharge the rapeseed oil.

The time when the rapeseed oil started to be discharged from the upper end opening of the container was set to 0 seconds, and after 600 seconds elapsed therefrom, the inclination was returned to the original state, and the amount of rapeseed oil remaining in the container (residual oil/fat amount) was measured. The test was performed at room temperature (23°C). When the residual oil/fat amount of the oil/fat storage container of Comparative Example 1 or Comparative Example 8 was taken as B (% by mass), and the residual oil/fat amount of the oil/fat storage container of each of the other Examples or Comparative Examples was taken as A (% by mass), the reduction ratio of the residual oil/fat amount was calculated from the following formula. $Reduction ratio of residual oil / fat amount \left(%\right) = \left(1-A/B\right) \times 100$

### (Residual Liquid Amount of Dressing)

Oil/fat storage containers of Examples and Comparative Examples were prepared as container samples. After inversion mixing was performed 100 times with the cap attached, the cap was removed and the upper end opening of the container was opened, and the container was quickly inclined at an angle of 160° relative to the vertical to discharge the internal solution (filled dressing). The time when the internal solution started to be discharged from the upper end opening of the container was set to 0 seconds, and after 600 seconds elapsed therefrom, the inclination was returned to the original state, and the amount of internal solution remaining in the container (residual liquid amount) was measured. The test was performed at room temperature (23°C). When the residual liquid amount of the oil/fat storage container of Comparative Example 1 was taken as D (% by mass), and the residual liquid amount of the oil/fat storage container of each of the other Examples was taken as C (% by mass), the reduction ratio of the residual liquid amount was calculated from the following formula. $Reduction ratio of residual liquid amount \left(%\right) = \left(1-C/D\right) \times 100$

### [Comparative Examples and Examples]

### (Plasma CVD Apparatus 1)

The film formation conditions by a plasma CVD apparatus 1 used in Comparative Examples 2 to 6 and Examples 1 to 5 are as shown in Table 1. In addition, settings of the plasma CVD apparatus 1 other than those shown in Table 1 are as follows.
Name: plasma CVD apparatus 1
Film formation method: PECVD (Plasma Enhanced Chemical Vapor Deposition)
Plasma source: CCP (Capacitively Coupled Plasma)
Electrode shape: similar type (relative to container shape)
External RF electrode: upper and lower 2-piece structure, no cooling mechanism
Internal gas introduction electrode: φ6.35 mm, no heating mechanism
Material: aluminum alloy (external electrode), SUS304 (internal electrode)
RF power supply: frequency 13.56 MHz
RF switch: for 2 ch
Matching method: automatic impedance matching
Exhaust configuration: mechanical booster pump (main evacuation), rotary pump (auxiliary)
Exhaust manifold external dimensions: 350 mm×350 mm×H150 mm

### (Plasma CVD Apparatus 2)

The film formation conditions by a plasma CVD apparatus 2 used in Comparative Example 7 and Examples 6 and 7 are as shown in Table 8. The plasma CVD apparatus 2 has the same settings as the plasma CVD apparatus 1 described above, except that the electrode portion of the plasma CVD apparatus 1 described above was changed to parallel-plate electrodes (interelectrode distance 50 mm, upper gas shower electrode: made of aluminum alloy and SUS304, heating type, φ320 mm, lower RF electrode: made of SUS304, water-cooled type, φ320 mm). The first electrode does not also serve as the plasma treatment chamber, and the apparatus has a structure in which the above parallel-plate first electrode and second electrode are installed in the plasma treatment chamber.

### <Experiment 1>

### (Preparation 1 of Silicon Oxide Vapor-Deposited Film and Molded Article)

An uncoated commercially available polyethylene terephthalate container for edible oil/fat (PET container: bottle shape, usable capacity 600 g, inner diameter of upper end opening 30.3 mm, height 218.7 mm, Comparative Example 1) was subjected to plasma treatment under the film formation conditions of Table 1 in an organosilicon compound atmosphere using the plasma CVD apparatus 1 (details are described above), thereby coating the PET container with a silicon oxide vapor-deposited film to obtain container samples of Comparative Examples 2 to 6 and Examples 1 to 4 (samples of containers for storing oil/fat).

In the container samples of Comparative Examples 2 to 6 and Examples 1 to 4, specifically, tetraethoxysilane (hereinafter sometimes referred to as TEOS), tetramethoxysilane (hereinafter sometimes referred to as TMOS), or hexamethyldisiloxane (hereinafter sometimes referred to as HMDSO) was used as the organosilicon compound. As needed, oxygen (O₂), as an oxidizing gas, was mixed with the organosilicon compound, and the resulting mixture was used as a reaction gas. In addition, as needed, helium (He) was used as a carrier gas for TEOS, and argon (Ar) was used as a discharge-stabilizing gas. First, the uncoated PET container was set in the plasma treatment chamber of the plasma CVD apparatus 1, and after the pressure in the plasma treatment chamber was reduced to 1 Pa or less, the reaction gas and optionally the carrier gas and discharge-stabilizing gas were introduced into the plasma treatment chamber at the flow rates shown in Table 1, the pressure was stabilized to the pressure shown in Table 1 over 30 seconds to 60 seconds, and then discharge was performed at the plasma output shown in Table 1 for the time shown in Table 1 to coat the surface of the PET container with a silicon oxide vapor-deposited film. After discharge, introduction of the reaction gas and optional carrier gas and discharge-stabilizing gas was stopped, the pressure in the film formation chamber was reduced to 1 Pa or less, and then the plasma treatment chamber was opened to the atmosphere, and the PET container was taken out of the plasma treatment chamber.

The PET container coated with the silicon oxide vapor-deposited film as described above was filled with 600 g of refined rapeseed oil ("Nisshin Canola Oil" manufactured by The Nisshin OilliO Group, Ltd.) and sealed to obtain a filled PET sample (container sample). The residual oil/fat amount and the reduction ratio of the residual oil/fat amount of the container sample were measured. In addition, a 2 cm square PET plate was cut out from a flat portion of the PET container (container sample) coated with the silicon oxide vapor-deposited film, and ion intensities and ratios thereof, film thickness, contact angle, and sliding property of oil/fat were analyzed and evaluated according to the above, and are shown in Table 2.

Further, the following storage test 1 or 2 was performed on the same container samples, and the reduction ratio of the residual oil/fat amount was measured ("residual oil/fat amount" and "reduction ratio of residual oil/fat amount" in Table 3 (storage test 1) and Table 4 (storage test 2)). In addition, after the reduction ratio of the residual oil/fat amount was measured, the containers were cut, and the contact angle and the sliding property of oil/fat were measured according to the above at portions to which no oil/fat was attached. The contact angle was measured after washing with hexane and drying. These results are shown in Table 3 (storage test 1) and Table 4 (storage test 2).

### (Storage Test 1: Accelerated Test)

The container samples of Comparative Examples 1 to 6 and Examples 1 to 4 were filled with about 600 g of refined rapeseed oil ("Nisshin Canola Oil" manufactured by The Nisshin OilliO Group, Ltd.), capped, and sealed. The sealed container samples containing the refined rapeseed oil were stored in a space at 60°C in a dark place for 8 weeks.

Since a chemical reaction is accelerated about 2 times when the temperature rises by 10°C, the results of the accelerated test for 8 weeks at 60°C described above correspond to results of storage for 128 weeks (8 weeks×16) at room temperature (20°C).

### (Storage Test 2: Light Exposure Test)

The sealed container samples containing the refined rapeseed oil were stored for 6 weeks at 20°C in a state of being irradiated with light of 1000 Lux.

**Table 1**

| | Comparative Example 1 | Comparative Example 2 | Comparative Example 3 | Comparative Example 4 | Comparative Example 5 | Comparative Example 6 | Example 1 | Example 2 | Example 3 | Example 4 |
|---|---|---|---|---|---|---|---|---|---|---|
| Raw material | - | TEOS | TEOS | TMOS | HMDSO | HMDSO | HMDSO | HMDSO | HMDSO | HMDSO |
| Raw material flow rate [sccm] | - | 53.8 | 10.8 | 10 | 20 | 50 | 50 | 50 | 50 | 10 |
| Oxygen flow rate [sccm] | - | 0 | 50 | 0 | 200 | 500 | 50 | 500 | 50 | 0 |
| Ar flow rate [sccm] | - | 0 | 0 | 0 | 0 | 0 | 0 | 0 | 0 | 50 |
| He flow rate [sccm] | - | 100 | 100 | 0 | 0 | 0 | 0 | 0 | 0 | 0 |
| Pressure [Pa] | - | 10 | 10 | 20 | 10 | 30 | 30 | 30 | 30 | 50 |
| Plasma output [W] | - | 100 | 100 | 100 | 300 | 1000 | 1000 | 100 | 100 | 100 |
| Time [seconds] | - | 15 | 15 | 10 | 10 | 2 | 2 | 10 | 10 | 10 |

**Table 2**

| | Comparative Example 1 | Comparative Example 2 | Comparative Example 3 | Comparative Example 4 | Comparative Example 5 | Comparative Example 6 | Example 1 | Example 2 | Example 3 | Example 4 |
|---|---|---|---|---|---|---|---|---|---|---|
| AO intensity | - | 4816 | 399 | 28278 | 28459 | 36074 | 48850 | 43251 | 63565 | 39829 |
| A intensity | - | 4349 | 13758 | 9615 | 63693 | 76267 | 118862 | 85475 | 204187 | 310300 |
| B intensity | - | 52730 | 10042 | 1679 | 2442 | 1413 | 482 | 708 | 223 | 3.0 |
| S intensity | - | 618 | 11305 | 1503 | 1990 | 1423 | 700 | 931 | 585 | 8.5 |
| R intensity | - | 65770 | 17887 | 2331 | 1810 | 1933 | 1518 | 895 | 577 | 221 |
| AO/B | - | 0.1 | 0.0 | 16.8 | 11.7 | 25.5 | 101.5 | 61.1 | 285.7 | 13276.3 |
| AO/A | - | 1.11 | 0.03 | 2.94 | 0.45 | 0.47 | 0.41 | 0.51 | 0.31 | 0.13 |
| (A+AO)/S | - | 14.8 | 1.3 | 25.2 | 46.3 | 79.0 | 239.6 | 138.3 | 457.7 | 41191.6 |
| AO/S | - | 7.8 | 0.0 | 18.8 | 14.3 | 25.4 | 69.8 | 46.5 | 108.7 | 4685.8 |
| A/S | - | 7.0 | 1.2 | 6.4 | 32.0 | 53.6 | 169.8 | 91.9 | 349.0 | 36505.8 |
| R/A | - | 15.1 | 1.3 | 0.2 | 0.0 | 0.0 | 0.0 | 0.0 | 0.0 | 0.0 |
| Film thickness | - | 253.3 | 72.3 | 10.1 | 195.3 | 85.4 | 122.6 | 91.5 | 12.3 | 253.3 |
| Residual oil/fat amount (after 600 seconds) | 1.53 g | 0.11 g | 0.61 g | 0.29 g | 0.21 g | 0.35 g | 0.32 g | 0.21 g | 0.13 g | 0.13 g |
| Ratio to residual oil/fat amount of Comparative Example 1 | - | 7.2% | 39.9% | 19.0% | 13.7% | 22.9% | 20.9% | 13.7% | 8.5% | 8.5% |
| (reduction ratio of residual oil/fat amount) | (-) | (92.8%) | (60.1%) | (81.0%) | (86.3%) | (77.1%) | (79.1%) | (86.3%) | (91.5%) | (91.5%) |
| Contact angle (°) | 7 or less | 41.6 | 17.8 | 28.9 | 42.1 | 41.9 | 43.4 | 47.0 | 50.1 | 53.6 |
| Sliding-off property of oil/fat (seconds) | more than 300 | 5 | 18 | 7 | 8 | 10 | 8 | 6 | 5 | 5 |
| Evaluation | E | A | B | A | A | A | A | A | A | A |

**Table 3**

| Storage Test 1 | Comparative Example 1 | Comparative Example 2 | Comparative Example 3 | Comparative Example 4 | Comparative Example 5 | Comparative Example 6 | Example 1 | Example 2 | Example 3 | Example 4 |
|---|---|---|---|---|---|---|---|---|---|---|
| Residual oil/fat amount (after 600 seconds) | 1.55 | 1.39 | 1.43 | 1.46 | 1.45 | 1.58 | 0.41 | 0.13 | 0.22 | 0.12 |
| Ratio to residual oil/fat amount of Comparative Example 1 | - | 89.7% | 92.3% | 94.2% | 93.6% | more than 100% | 26.5% | 8.4% | 14.2% | 7.7% |
| (reduction ratio of residual oil/fat amount) | (-) | (10.3%) | (7.7%) | (5.8%) | (6.4%) | (0%) | (73.5%) | (91.6%) | (85.8%) | (92.3%) |
| Contact angle (°) | 7 or less | 7.2 | 18.2 | 13.6 | 26.5 | 21.0 | 38.5 | 38.3 | 49.0 | 55.2 |
| Sliding-off property of oil/fat (seconds) | more than 300 | 107 | 69 | 259 | 69 | more than 300 | 12 | 27 | 7 | 6 |
| Evaluation | E | D | D | D | D | E | B | C | A | A |

**Table 4**

| Storage Test 2 | Comparative Example 1 | Comparative Example 2 | Comparative Example 4 | Comparative Example 5 | Comparative Example 6 | Example 1 | Example 2 | Example 3 | Example 4 |
|---|---|---|---|---|---|---|---|---|---|
| Residual oil/fat amount (after 600 seconds) | 1.55 | 1.35 | 1.42 | 1.41 | 1.47 | 0.36 | 0.74 | 0.33 | 0.14 |
| Ratio to residual oil/fat amount of Comparative Example 1 | - | 87.1% | 91.6% | 91.0% | 94.8% | 23.2% | 47.7% | 21.3% | 9.0% |
| (reduction ratio of residual oil/fat amount) | (-) | (12.9%) | (8.4%) | (9.0%) | (5.2%) | (76.8%) | (52.3%) | (78.7%) | (91.0%) |
| Contact angle (°) | 7 or less | 22.7 | 10.3 | 32.4 | 30.8 | 41.5 | 43.5 | 50.4 | 52.9 |
| Sliding-off property of oil/fat (seconds) | more than 300 | 162 | more than 300 | 65 | more than 300 | 10 | 10 | 6 | 9 |
| Evaluation | E | D | E | D | E | A | A | A | A |

### <Experiment 2>

### (Preparation 2 of Silicon Oxide Vapor-Deposited Film and Molded Article)

An uncoated commercially available polyethylene terephthalate container for edible oil/fat (PET container: bottle shape, usable capacity 600 g, inner diameter of upper end opening 30.3 mm, height 218.7 mm, Comparative Example 1) was subjected to plasma treatment in the same manner as in Preparation 1 of a silicon oxide vapor-deposited film and molded article under the film formation conditions of Table 5 using the plasma CVD apparatus 1 (details are described above), thereby coating the PET container with a silicon oxide vapor-deposited film to obtain container samples of Examples 4 and 5 (samples of containers for storing oil/fat). The container samples of Comparative Example 1 and Example 4 were produced under the same conditions as in Experiment 1.

The PET container (container sample) coated with the silicon oxide vapor-deposited film as described above was filled with 600 g of emulsified dressing (commercial product name "Nisshin Dressing Diet Mild Sesame Flavor," manufactured by The Nisshin OilliO Group, Ltd.: oil/fat 12% by mass (as liquid oil)) or separated dressing (commercial product name "Nisshin Dressing Diet Umakuchi Japanese-Style," manufactured by The Nisshin OilliO Group, Ltd.: oil/fat 12% by mass (as liquid oil)), and the reduction ratio of the residual liquid amount was measured. The results are shown in Table 6.

Further, the following storage test 3 was performed on the same container samples, and the reduction ratio of the residual liquid amount was measured. The results are shown in Table 7 (storage test 3).

### (Storage Test 3: Accelerated Test of Dressing)

The container samples of Comparative Example 1, Example 4, and Example 5 were filled with about 600 g of the emulsified dressing or separated dressing, capped, and sealed. The sealed container samples containing the dressing were stored in a space at 40°C in a dark place for 16 weeks.

**Table 5**

| | Comparative Example 1 | Example 4 | Example 5 |
|---|---|---|---|
| Raw material | - | HMDSO | HMDSO |
| Raw material flow rate [sccm] | - | 10 | 50 |
| Oxygen flow rate [sccm] | - | 0 | 0 |
| Ar flow rate [sccm] | - | 50 | 50 |
| He flow rate [sccm] | - | 0 | 0 |
| Pressure [Pa] | - | 50 | 30 |
| Plasma output [W] | - | 100 | 1000 |
| Time [seconds] | - | 10 | 2 |

**Table 6**

| | | Comparative Example 1 | Example 4 | Example 5 |
|---|---|---|---|---|
| AO intensity | | - | 39829 | 35104 |
| A intensity | | - | 310300 | 162715 |
| B intensity | | - | 3.0 | 177 |
| S intensity | | - | 8.5 | 189 |
| R intensity | | - | 221 | 1361 |
| AO/B | | - | 13276.3 | 198.3 |
| AO/A | | - | 0.13 | 0.22 |
| (A+AO)/S | | - | 41191.6 | 1046.7 |
| AO/S | | - | 4685.8 | 185.7 |
| A/S | | - | 36505.8 | 860.9 |
| R/A | | - | 0.0 | 0.0 |
| Emulsified dressing | Residual liquid amount (after 600 seconds) | 19.55 g | 2.23 g | 13.21 g |
| | Ratio to residual liquid amount of Comparative Example 1 | - | 11.4% | 67.6% |
| | (reduction ratio of residual liquid amount) | (-) | (88.6%) | (32.4%) |
| Separated dressing | Residual liquid amount (after 600 seconds) | 3.17 g | 0.77 g | 1.18 g |
| | Ratio to residual liquid amount of Comparative Example 1 | - | 24.2% | 37.2% |
| | (reduction ratio of residual liquid amount) | (-) | (75.8%) | (62.8%) |

**Table 7**

| Storage Test 3 | | Comparative Example 1 | Example 4 | Example 5 |
|---|---|---|---|---|
| Emulsified dressing | Residual liquid amount (after 600 seconds) | 12.58 g | 4.77 g | 9.08 g |
| | Ratio to residual liquid amount of Comparative Example 1 | - | 37.9% | 72.2% |
| | (reduction ratio of residual liquid amount) | (-) | (62.1%) | (27.8%) |
| Separated dressing | Residual liquid amount (after 600 seconds) | 3.79 g | 2.12 g | 2.68 g |
| | Ratio to residual liquid amount of Comparative Example 1 | - | 55.9% | 70.7% |
| | (reduction ratio of residual liquid amount) | (-) | (44.1%) | (29.3%) |

### <Experiment 3>

### (Preparation 3 of Silicon Oxide Vapor-Deposited Film and Molded Article)

Using uncoated commercially available mirror-polished (#800) stainless steel plates (SUS304, length 20 mm, width 20 mm, thickness 1 mm), plasma treatment was performed under the film formation conditions of Table 8 in an organosilicon compound atmosphere to coat the stainless steel plates with a silicon oxide vapor-deposited film, thereby obtaining stainless steel plate samples of Comparative Example 7 and Examples 6 and 7.

In the stainless steel plate samples of Comparative Example 7 and Examples 6 and 7, specifically, hexamethyldisiloxane (hereinafter sometimes referred to as HMDSO) was used as the organosilicon compound. As needed, oxygen (O₂), as an oxidizing gas, was mixed with the organosilicon compound, and the resulting mixture was used as a reaction gas. In addition, as needed, argon (Ar) was used as a discharge-stabilizing gas. First, the uncoated stainless steel plate was set in the plasma treatment chamber of the plasma CVD apparatus 2, and after the pressure in the plasma treatment chamber was reduced to 5 Pa or less, the reaction gas and optionally the discharge-stabilizing gas were introduced into the plasma treatment chamber at the flow rates shown in Table 8, the pressure was stabilized to the pressure shown in Table 8 over 30 seconds to 60 seconds, and then discharge was performed at the plasma output shown in Table 8 for the time shown in Table 8 to coat the surface of the stainless steel plate with a silicon oxide vapor-deposited film. After discharge, introduction of the reaction gas and optional discharge-stabilizing gas was stopped, the pressure in the film formation chamber was reduced to 5 Pa or less, and then the plasma treatment chamber was opened to the atmosphere, and the stainless steel plate was taken out of the plasma treatment chamber.

Ion intensities and ratios thereof, contact angle, and sliding property of oil/fat of the stainless steel plate samples coated with the silicon oxide vapor-deposited film as described above were analyzed and evaluated, and are shown in Table 9.

Further, the following storage test 4 was performed on the same stainless steel plate samples, and the contact angle and the sliding property of oil/fat were measured according to the above at portions to which no oil/fat was attached. The contact angle was measured after washing with hexane and drying. These results are shown in Table 10 (storage test 4).

### (Storage Test 4: Heating Test)

An electric fryer (manufactured by Zojirushi Corporation, product number: EFK-A10) was filled with about 2 kg of refined rapeseed oil ("Nisshin Canola Oil" manufactured by The Nisshin OilliO Group, Ltd.), the oil temperature was adjusted to 180°C, and then the stainless steel plate samples of Comparative Example 7 and Examples 6 and 7 were placed in the oil and stored for 30 minutes. The stainless steel plate samples were placed so as not to directly contact the heat source.

**Table 8**

| | Comparative Example 7 | Example 6 | Example 7 |
|---|---|---|---|
| Raw material | HMDSO | HMDSO | HMDSO |
| Raw material flow rate [sccm] | 10 | 50 | 50 |
| Oxygen flow rate [sccm] | 50 | 0 | 500 |
| Ar flow rate [sccm] | 0 | 50 | 0 |
| He flow rate [sccm] | 0 | 0 | 0 |
| Pressure [Pa] | 11 | 50 | 50 |
| Plasma output [W] | 300 | 100 | 300 |
| Time [seconds] | 30 | 30 | 30 |

**Table 9**

| | Comparative Example 7 | Example 6 | Example 7 |
|---|---|---|---|
| AO intensity | 22946 | 17206 | 58668 |
| A intensity | 75977 | 207136 | 153529 |
| B intensity | 3291 | 4 | 467 |
| S intensity | 1488 | 302 | 814 |
| R intensity | 5357 | 3700 | 1080 |
| AO/B | 7.0 | 4301.5 | 125.7 |
| AO/A | 0.30 | 0.08 | 0.38 |
| (A+AO)/S | 66.5 | 742.9 | 260.8 |
| AO/S | 15.4 | 57.0 | 72.1 |
| A/S | 51.1 | 685.9 | 188.7 |
| R/A | 0.1 | 0.0 | 0.0 |
| Contact angle (°) | 37.8 | 53.4 | 51.2 |
| Sliding-off property of oil (seconds) | 56 | 10 | 16 |
| Evaluation | C | A | B |

**Table 10**

| Storage Test 4 | Comparative Example 7 | Example 6 | Example 7 |
|---|---|---|---|
| Contact angle (°) | 17.6 | 54.8 | 35.0 |
| Sliding-off property of oil/fat (seconds) | more than 300 | 17 | 31 |
| Evaluation | E | B | C |

### <Experiment 4>

### (Preparation 4 of Silicon Oxide Vapor-Deposited Film and Molded Article)

An uncoated polyethylene film (low-density PE film: thickness 120 µm) was cut into a 20 cm square to obtain Comparative Example 8. An evaluation sample treated in the same manner as in Comparative Example 8 was subjected to plasma treatment under the film formation conditions of Table 11 in an organosilicon compound atmosphere using the plasma CVD apparatus 2, thereby coating the polyethylene film with a silicon oxide vapor-deposited film to obtain film samples of Examples 8 and 9.

In the film samples of Examples 8 and 9, specifically, hexamethyldisiloxane was used as the organosilicon compound. As needed, oxygen (O₂), as an oxidizing gas, was mixed with the organosilicon compound, and the resulting mixture was used as a reaction gas. In addition, as needed, argon (Ar) was used as a discharge-stabilizing gas. First, the uncoated polyethylene film was set in the plasma treatment chamber of the plasma CVD apparatus 2, and after the pressure in the plasma treatment chamber was reduced to 5 Pa or less, the reaction gas and optionally the discharge-stabilizing gas were introduced into the plasma treatment chamber at the flow rates shown in Table 11, the pressure was stabilized to the pressure shown in Table 11 over 30 seconds to 60 seconds, and then discharge was performed at the plasma output shown in Table 11 for the time shown in Table 11 to coat the surface of the polyethylene film with a silicon oxide vapor-deposited film. After discharge, introduction of the reaction gas and optional discharge-stabilizing gas was stopped, the pressure in the film formation chamber was reduced to 5 Pa or less, and then the plasma treatment chamber was opened to the atmosphere, and the polyethylene film was taken out of the plasma treatment chamber.

Ion intensities and ratios thereof of the polyethylene film samples coated with the silicon oxide vapor-deposited film as described above were analyzed. The analysis results are shown in Table 12. In addition, the polyethylene film samples were formed into a pillow shape (dimensions: width 10 cm, height 20 cm, opening dimension: circumference 19 cm), filled with 250 g of refined rapeseed oil ("Nisshin Canola Oil" manufactured by The Nisshin OilliO Group, Ltd.), and sealed at the opening by heat sealing to produce a plurality of filled pillow samples. The filled pillow samples were evaluated for the reduction ratio of residual oil/fat amount according to the following. The evaluation results are shown in Table 12.

Further, the following storage test 5 was performed on the filled pillow samples, and the reduction ratio of residual oil/fat amount was evaluated according to the following. The evaluation results are shown in Table 13.

### (Storage Test 5: Accelerated Test)

The filled pillow samples of Comparative Example 8, Example 8, and Example 9 were stored in a space at 60°C in a dark place for 8 weeks.

**Table 11**

| | Example 8 | Example 9 |
|---|---|---|
| Raw material | HMDSO | HMDSO |
| Raw material flow rate [sccm] | 40 | 10 |
| Oxygen flow rate [sccm] | 100 | 0 |
| Ar flow rate [sccm] | 0 | 50 |
| He flow rate [sccm] | 0 | 0 |
| Pressure [Pa] | 20 | 10 |
| Plasma output [W] | 100 | 100 |
| Time [seconds] | 30 | 30 |

**Table 12**

| | Comparative Example 8 | Example 8 | Example 9 |
|---|---|---|---|
| AO intensity | - | 66492 | 226 |
| A intensity | - | - | 27747 |
| B intensity | - | 18 | 9 |
| S intensity | - | 439 | 1 |
| R intensity | - | 4865 | 2 |
| AO/B | - | 3799.5 | 26.6 |
| AO/A | - | - | 0.01 |
| (A+AO)/S | - | - | 27973.0 |
| AO/S | - | 151.5 | 226.0 |
| A/S | - | - | 27747.0 |
| R/A | - | - | 0.0 |
| Residual oil/fat amount (after 600 seconds) | 1.17 g | 0.27 g | 0.23 g |
| Ratio to residual oil/fat amount of Comparative Example 8 (reduction ratio of residual oil/fat amount) | - | 23.1% | 19.7% |
| | (-) | (76.9%) | (80.3%) |

**Table 13**

| Storage Test 5 | Comparative Example 8 | Example 8 | Example 9 |
|---|---|---|---|
| Residual oil/fat amount (after 600 seconds) | 1.48 g | 0.69 g | 0.64 g |
| Ratio to residual oil/fat amount of Comparative Example 8 | - | 46.6% | 43.2% |
| (reduction ratio of residual oil/fat amount) | (-) | (53.4%) | (56.8%) |

## Claims

1. A silicon oxide vapor-deposited film, wherein a surface of the silicon oxide vapor-deposited film has, in ion intensities obtained by time-of-flight secondary ion mass spectrometry, a ratio of ion intensity AO to ion intensity B (ion intensity AO/ion intensity B) of 26 or more,
where the ion intensity B is a sum of the intensities of respective ions of a positive ion at m/z 78.99 and a positive ion at m/z 138.95, and the ion intensity AO is a sum of the intensities of respective ions of a negative ion at m/z 31.02, a negative ion at m/z 59.00, a negative ion at m/z 74.99, a positive ion at m/z 102.97, and a negative ion at m/z 134.96.

2. The silicon oxide vapor-deposited film according to claim 1, wherein the surface of the silicon oxide vapor-deposited film has, in ion intensities obtained by time-of-flight secondary ion mass spectrometry, a ratio of ion intensity R to ion intensity A (ion intensity R/ion intensity A) of 0.3 or less,
where the ion intensity A is a sum of the intensities of respective ions of a positive ion at m/z 43.00, a positive ion at m/z 59.03, and a positive ion at m/z 73.05, and the ion intensity R is a total value of the ion intensities of respective ions of a positive ion at m/z 29.04 and a positive ion at m/z 55.06.

3. The silicon oxide vapor-deposited film according to claim 1 or 2, wherein the surface of the silicon oxide vapor-deposited film has, in ion intensities obtained by time-of-flight secondary ion mass spectrometry, a ratio of the ion intensity AO to the ion intensity A (ion intensity AO/ion intensity A) of 0.1 or more, and/or a ratio of the total of the ion intensity A and the ion intensity AO to ion intensity S ((ion intensity A+ion intensity AO)/ion intensity S) of 100 or more, and/or a ratio of the ion intensity AO to ion intensity S (ion intensity AO/ion intensity S) of 30 or more,
where the ion intensity S is an intensity of a positive ion at m/z 43.97, and the ion intensity A is the sum of the intensities of respective ions of a positive ion at m/z 43.00, a positive ion at m/z 59.03, and a positive ion at m/z 73.05.

4. The silicon oxide vapor-deposited film according to any one of claims 1 to 3, wherein the silicon oxide vapor-deposited film has a sliding property of 300 seconds or less in the following sliding property test of oil/fat when rapeseed oil is used as the oil:
sliding property of oil/fat: time (seconds) required for a rear end of an oil/fat droplet of 24±0.5 mg of rapeseed oil on a surface of a silicon oxide vapor-deposited film sample inclined at 70° relative to the vertical to move 6 mm on the sample surface at 23±3°C.

5. The silicon oxide vapor-deposited film according to any one of claims 1 to 4, wherein the silicon oxide vapor-deposited film is a film derived from hexamethyldisiloxane.

6. A molded article having a surface coated with the silicon oxide vapor-deposited film according to any one of claims 1 to 5.

7. The molded article according to claim 6, wherein the molded article is a container, piping, or a cooking utensil molded from a material selected from resin, glass, metal, ceramic clay, and paper.

8. A method for producing a molded article coated with the silicon oxide vapor-deposited film, the method comprising: (A) a step of preparing a molded article; and (B) a step of coating a surface of the molded article with the silicon oxide vapor-deposited film according to any one of claims 1 to 5.

9. The production method according to claim 8, wherein the coating is performed by a plasma CVD method using an organosilicon compound and an optional oxidizing gas as reaction gases.

10. The production method according to claim 8 or 9, wherein the silicon oxide vapor-deposited film is a film derived from hexamethyldisiloxane.
